# EUROPEAN PATENT SPECIFICATION

(11) **EP 2 235 667 B1**
(45) Date of publication and mention of the grant of the patent: **10.10.2012**
(21) Application number: 09703547.1
(22) Date of filing: 25.01.2009
(51) Int. Cl.: G06K 19/077, G01V 3/28, H01L 23/498, H01Q 1/36, H01Q 7/00, H05K 3/00

(54) **MANUFACTURE OF A SMART CARD**
HERSTELLUNG EINER CHIPKARTE
PROCÉDÉS DE FABRICATION D'UNE CARTE À PUCE

(30) Priority: 23.01.2008 US 62164
(43) Date of publication of application: 06.10.2010
(73) Proprietor: Smartrac IP B.V., 1077 XX Amsterdam (NL)
(72) Inventor: BASHAN, Oded, 12000 Rosh Pina (IL); SHAFRAN, Guy, Hong Kong (CN); RAHAV, Tom, 15241 Kfar Tavor (IL)
(74) Representative: Böck, Bernhard
(86) International application number: PCT/IL2009/000095
(87) International publication number: WO 2009/093248

(56) References cited:
- DE-A1- 4 410 732
- DE-A1- 4 421 607
- DE-A1-102006 001 777
- US-A- 5 809 633
- US-A1- 2001 011 413
- US-A1- 2004 129 786
- US-B1- 6 233 818
- US-B1- 6 849 936

## Description

### FIELD OF THE INVENTION

The present invention relates to the manufacture of wireless transponder units such as those employed in smart cards having contactless functionality.

### BACKGROUND OF THE INVENTION

The following U.S. patent documents are believed to represent the current state of the art:
7,278,580; 7,271,039; 7,269,021; 7,243,840; 7,240,847 and 7,204,427.67666

DE 44 10 732 A1 discloses a method for the manufacture of a smart card and a smart card comprising an IC and a coil comprising transponder unit. The method comprises the connecting of one end of the coil wire to a contact pad of the IC, the laying and connecting of the coil wire onto/to a substrate and the connecting of the second end of the coil wire to a contact pad of the IC. The laying of the coil wire and the connecting to the contact pads is performed by a combined wire dispense needle and bonding device which is movable in three dimensions relative to the substrate.

US 5 809 633 A teaches a method for producing a smart card module in which again comprises bonding a first end of a wire onto a contact zone of a semiconductor chip, guiding the wire in a plurality of turns to form an antenna coil and bonding a second end of the wire to a second contact zone of a semiconductor chip. The antenna coil and the chip are then placed on a Carrier body. The independent claims are delimited against this document.

DE 44 21 607 A1 concerns a process the manufacture of a smart card, where a preformed wire coil is placed on and subsequently integrated into a carrier foil. Afterwards an IC gets connected to the ends of the wire coil via bonding wires.

DE 10 2006 001 777 A1 discloses a method for the manufacture of a device containing a transponder unit. The devices comprises metal wire coil and a IC chip connected to the coil, wherein the coil is at least partly embedded into a thermoplastic material by the heat generated from the application of electric current to the coil.

### SUMMARY OF THE INVENTION

The present invention seeks to provide improved methods of manufacturing wireless transponder units useful as smart card inlays.

The invention is defined by the independent claims. Preferred embodiments are set out in the dependent claims.

The present invention will be understood and appreciated more fully from the following detailed description, taken in conjunction with the drawings in which:
Figs. 1A, 1B, 1C & 1D are simplified illustrations of four steps in a method for manufacture of a wireless transponder in accordance with the prior art;
Figs. 2A & 2B are simplified illustrations of a method for manufacture of a wireless transponder in accordance with the prior art;
Figs. 3A, 3B and 3C are together a simplified illustration of a method for manufacture of a wireless transponder in accordance with the prior art;
Figs. 4A and 4B are simplified illustrations of two steps in a method for manufacture of a wireless transponder in accordance with the prior art;
Figs. 5A and 5B are simplified illustrations of two steps in a general method for manufacture of a wireless transponder in accordance with the prior art;
Figs. 6A, 6B, 6C, 6D and 6E are simplified illustrations of one example of carrying out the general method of Figs. 5A & 5B;
Figs. 7A and 7B are simplified illustrations of two steps in a general method for manufacture of a wireless transponder in accordance with an embodiment of the present invention;
Figs. 8A, 8B, 8C, 80, 8E, 8F, 8G and 8H are simplified illustrations of one example of carrying out the general method of Figs. 7A & 7B;
Figs. 9A and 9B are simplified illustrations of two steps in a method for manufacture of a wireless transponder in accordance with a comparative example not forming an embodiment of the present invention; and
Figs. 10A, 10B, 10C, 10D and 10E are simplified illustrations of one example of carrying out the general method of Figs. 9A & 9B.

### DETAILED DESCRIPTION OF PREFERRED EMBODIMENTS

The description which follows includes several embodiments which may be employed singly or in any combination in the manufacture of a wireless transponder, such as that used in a smart card inlay or any other suitable device.

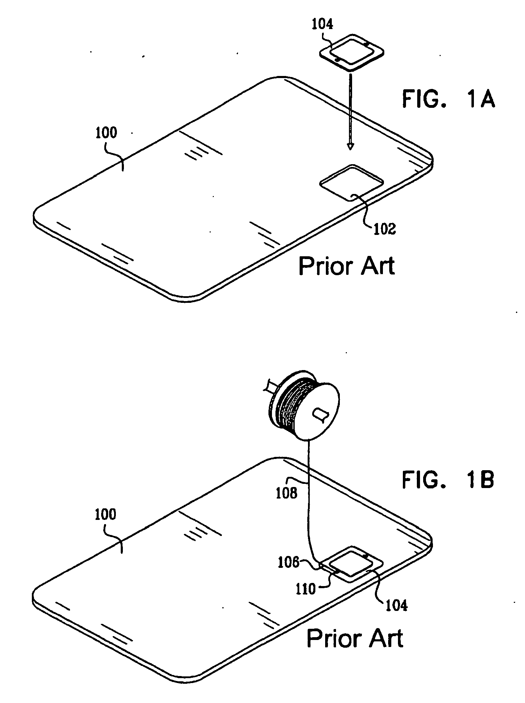

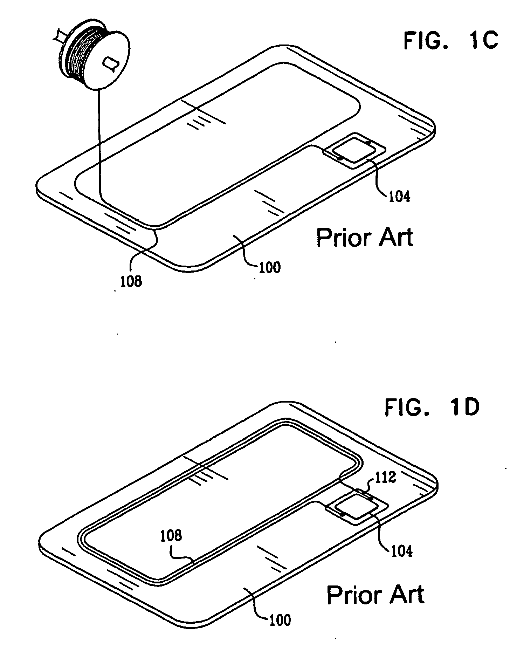

Reference is now made to Figs. 1A, 1B, 1C & 1D, which are simplified illustrations of steps in a method for manufacture of a wireless transponder in accordance with the prior art.

In the process for manufacturing a smart card inlay as shown in Figs. 1A-1D, Fig. 1A shows an apertured card substrate 100, including an aperture 102, and a chip module 104 about to be mounted in the aperture 102. Fig. 1B shows chip module 104 mounted in the aperture 102 and also illustrates initially connecting a first end 106 of a wire antenna 108 to a terminal 110 of chip module 104. Fig. 1C illustrates the stage of thereafter fixing the wire antenna 108 onto substrate 100 and Fig. 1D illustrates the stage of thereafter connecting a second end 112 of the wire antenna 108 to the chip module 104.

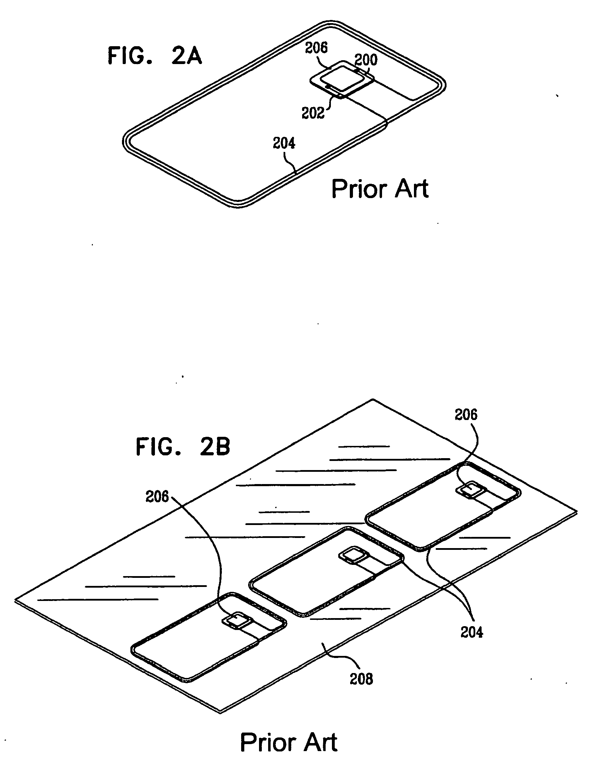

Reference is now made to Figs. 2A & 2B, which are simplified illustrations of a method for manufacture of a wireless transponder in accordance with the prior art.

In the process for manufacturing a smart card inlay as shown in Figs. 2A and 2B, a first end 200 and a second end 202 of a wire antenna 204 are initially connected to a chip module 206, such that the first end 200 and the second end 202 do not extend past the chip module 206. The wire antenna 204 may be fixed to a substrate 208 before or after connection to the chip module 206. Substrate 208 preferably includes suitable apertures for the placement therein of chip modules 206 of wire antennas 204.

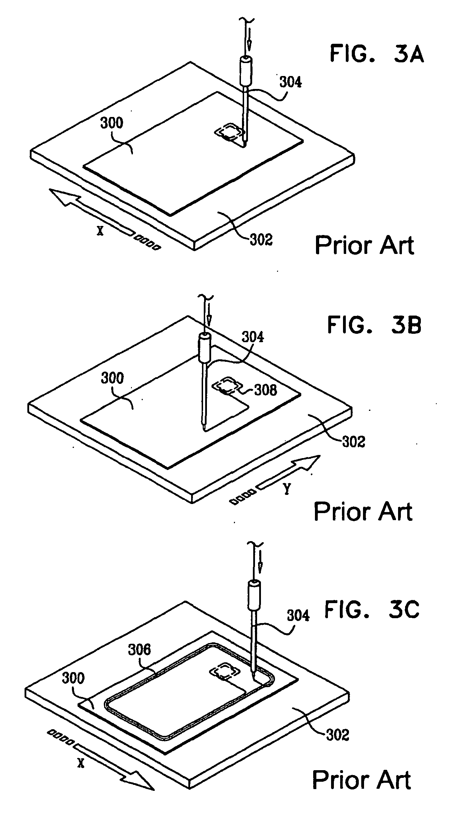

Reference is now made to Figs. 3A, 3B and 3C, which together are a simplified illustration of a method for manufacture of a wireless transponder in accordance with the prior art.

In the process for manufacturing a smart card inlay as shown in Figs. 3A-3C, a substrate 300 is removably mounted onto a movable surface 302 and is moved relative to a fixed wire embedding device 304 for connecting first and second ends of a wire antenna 306 to a chip module 308 and fixing the wire antenna 306 to substrate 300.

It is appreciated that the technique of Figs. 3A - 3C may be employed in combination with any other suitable one of the embodiments of the present invention or suitable combinations thereof.

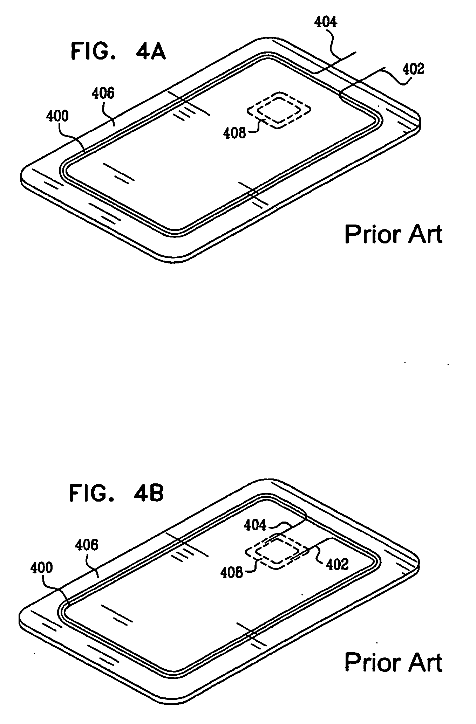

Reference is now made to Figs. 4A and 4B, which are simplified illustrations of two steps in a method for manufacture of a wireless transponder in accordance with the prior art.

In the process for manufacturing a smart card inlay as shown in Figs. 4A & 4B, Fig. 4A shows attaching a wire antenna 400, having first and second ends 402 and 404 respectively, to a substrate 406 where the first and second ends 402 and 404 are not adjacent the chip module area 408 in the substrate 406 and Fig. 4B shows thereafter relocating the first and second ends 402 and 404 of wire antenna 400 to locations suitable for attachment to a chip module (not shown). It is appreciated that a chip module (not shown) is preferably placed in chip module area 408 for attachment to first and second ends 402 and 404 of wire antenna 400. The chip module may be placed in chip module area 408 either before or after first and second ends 402 and 404 of wire antenna 400 are relocated.

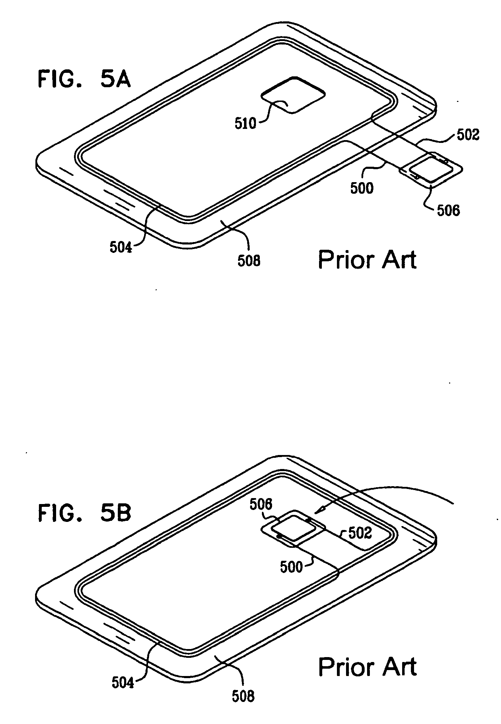

Reference is now made to Figs. 5A and 5B, which are simplified illustrations of two steps in a general method for manufacture of a wireless transponder in accordance with the prior art.

In the method for manufacturing a smart card inlay as shown in Figs. 5A & 5B, Fig. 5A illustrates connecting first and second ends 500 and 502 of a wire antenna 504 to a chip module 506 and fixing the wire antenna 504 to a substrate 508 and Fig. 5B illustrates thereafter relocating the chip module 506 to a chip module location 510 on the substrate 508.

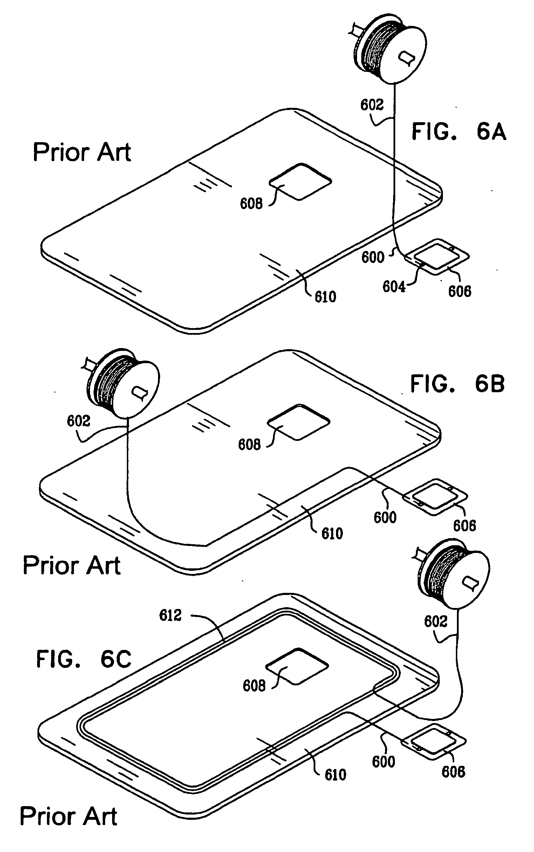

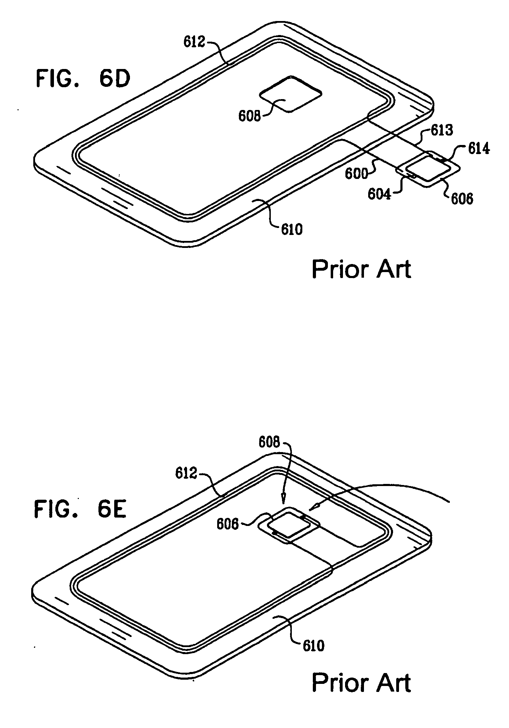

A manual manufacturing process suitable for carrying out the general method of Figs. 5A and 5B is illustrated in Figs. 6A, 6B, 6C, 60 & 6E, it being appreciated that a corresponding automated manufacturing process may readily be provided.

As seen in Fig. 6A, initially a first end 600 of wire 602 used for forming a wire antenna is attached to a first terminal 604 of a chip module 606, while the chip module 606 is located at a location other than the intended location 608 of the chip module 606, which may be an aperture formed on a substrate 610.

Figs. 6B and 6C together show a wire antenna 612 being formed from wire 602 on substrate 610 and Fig. 6D shows attachment of a second end 613 of wire 602 to a second terminal 614 of chip module 606 subsequent to formation of the wire antenna 612 on substrate 610.

Fig. 6E shows subsequent relocation of the chip module 606 to the intended location 608 of the chip module 606 on substrate 610.

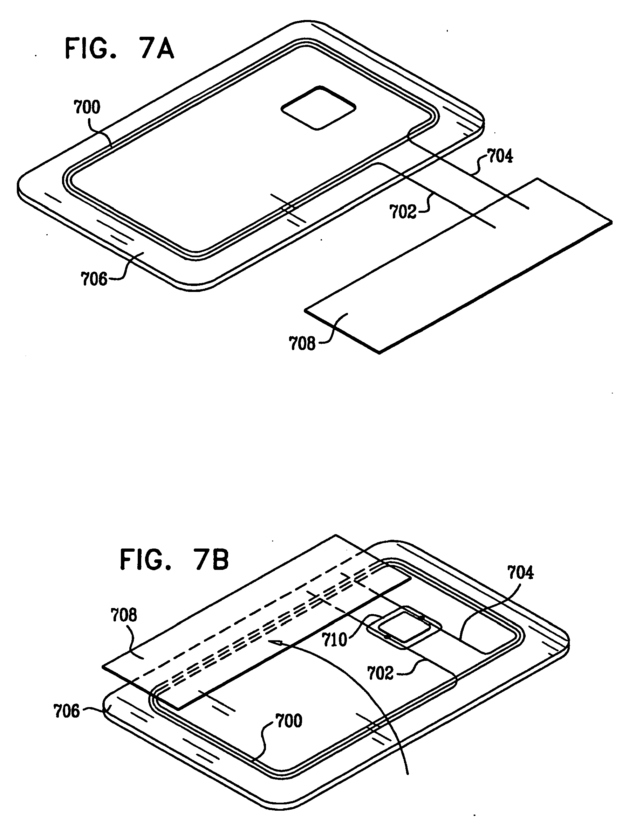

Reference is now made to Figs. 7A and 7B, which are simplified illustrations of two stages in a method for manufacture of a wireless transponder in accordance with an embodiment of the present invention.

In the process for manufacturing a smart card inlay as shown in Figs. 7A & 7B, Fig. 7A illustrates attaching a wire antenna 700, aside from first end 702 and second end 704 thereof, respectively, to a main substrate 706 and attaching the first and second ends 702 and 704 of the wire antenna 700 to an auxiliary substrate 708. Fig. 7B illustrates a following step of thereafter relocating the auxiliary substrate 708 such that the first and second ends 702 and 704 of the wire antenna 700 are at locations which are suitable for attachment to a chip module 710 on the main substrate 706.

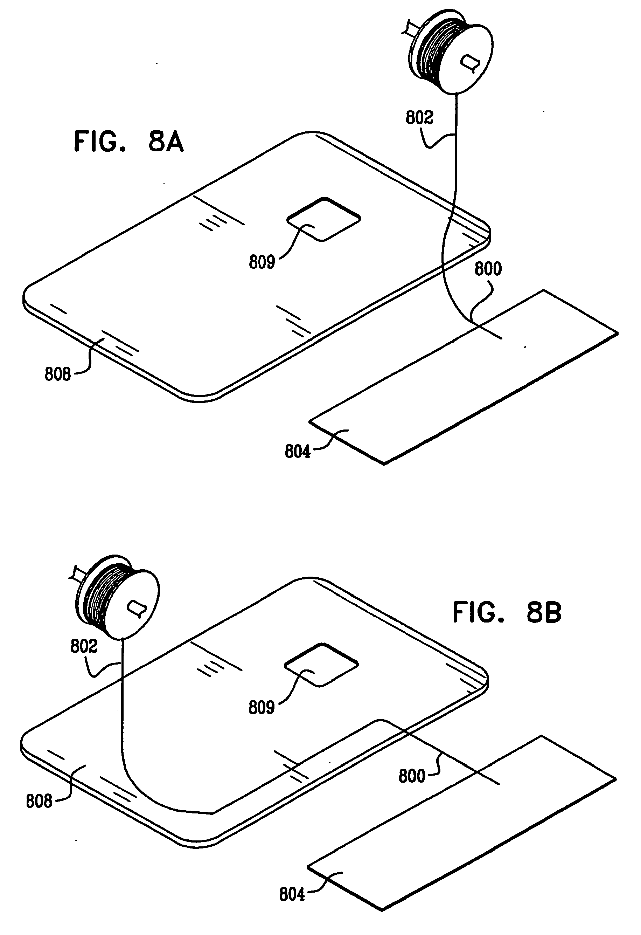

A manual manufacturing process suitable for carrying out the method of Figs. 7A and 7B is illustrated in Figs. 8A - 8H, it being appreciated that a corresponding automated manufacturing process may readily be provided.

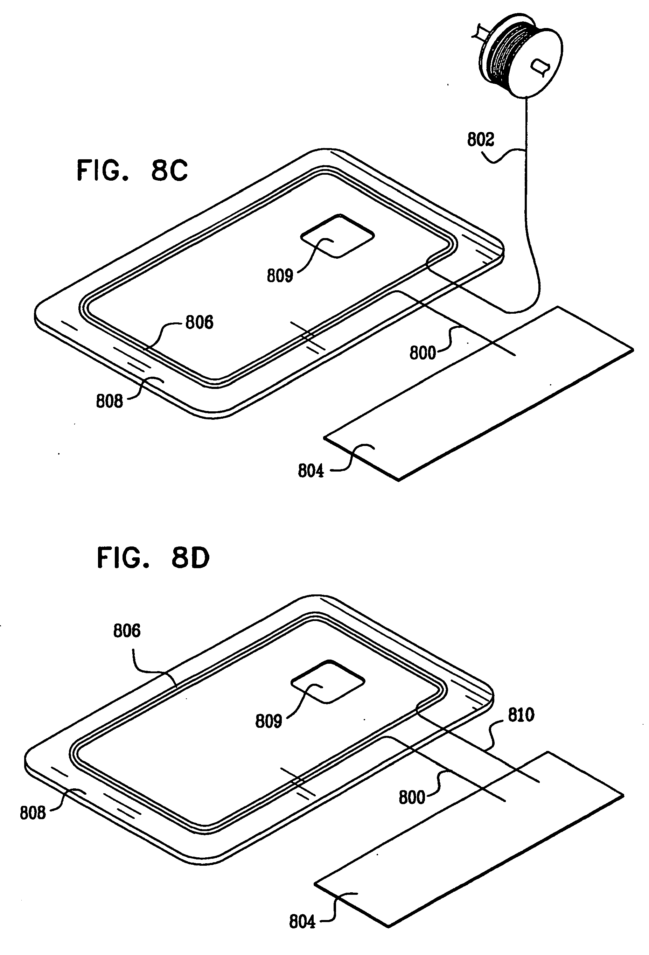

As seen in Fig. 8A, a first end 800 of antenna wire 802 is attached to an auxiliary substrate 804. Figs. 8B & 8C together show a wire antenna 806 being formed from antenna wire 802 on a main substrate 808 in an otherwise conventional manner, such as by ultrasonic embedding. A chip module aperture 809 is formed in main substrate 808. Fig. 8D shows attachment of a second end 810 of the antenna wire 802, forming the wire antenna 806, to the auxiliary substrate 804.

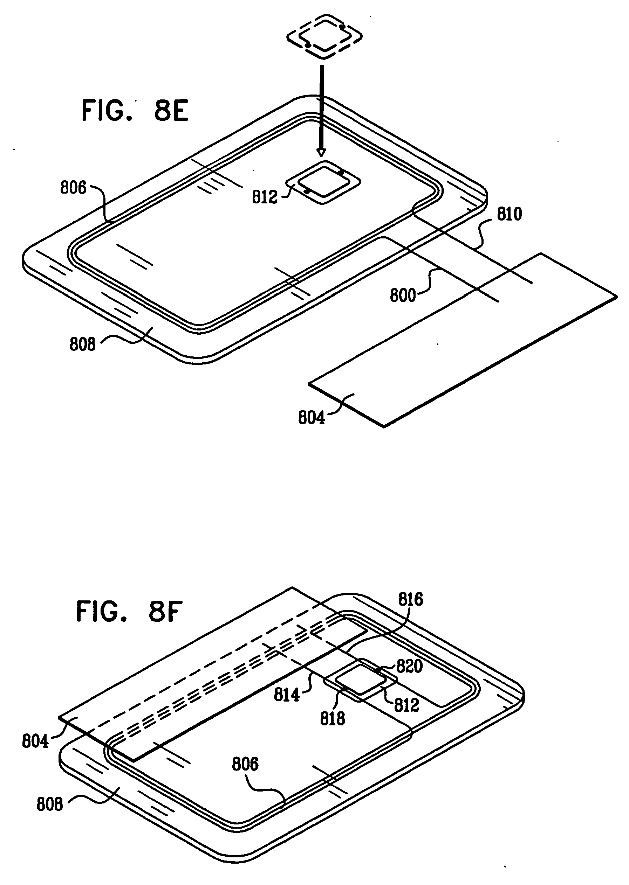

Fig. 8E shows mounting of a chip module 812 in aperture 809 in the main substrate 808, following formation of the wire antenna 806. Altenatively, the chip module 812 may be placed in aperture 809 before forming wire antenna 806. In a further alternative embodiment, aperture 809 may be obviated and chip module 812 may be placed directly on the main substrate 808.

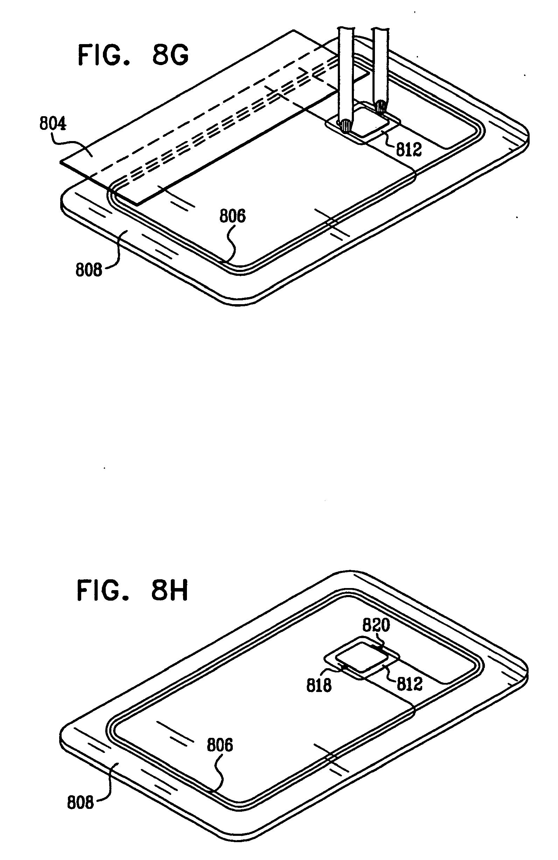

Fig. 8F shows repositioning of the auxiliary substrate 804 such that portions 814 and 816 of the antenna wire 802, which define first and second ends of the wire antenna 806, overlie corresponding terminals 818 and 820 of chip module 812 on the main substrate 808. Fig. 8G shows attachment of portions 814 and 816 to respective terminals 818 and 820 of chip module 812 and Fig. 8H shows a thus assembled smart card inlay after removal of the auxiliary substrate 804.

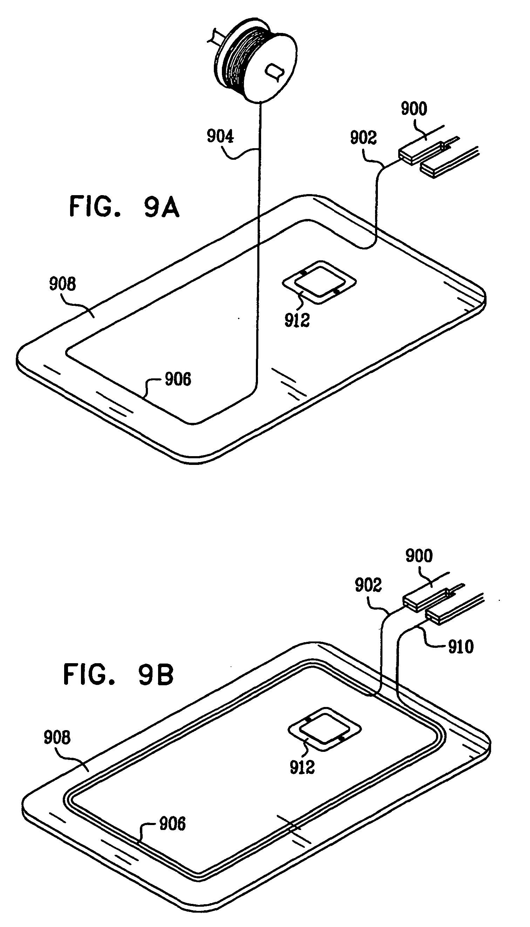

Reference is now made to Figs. 9A and 9B, which are simplified illustrations of two steps in a method for manufacture of a wireless transponder in accordance with a comparative example not forming an embodiment of the present invention.

In the process for manufacturing a smart card inlay as shown in Figs. 9A & 9B, a holding device 900 initially holds a first end 902 of an antenna wire 904 while a wire antenna 906 is formed therefrom on a substrate 908 by conventional techniques. Following formation of the wire antenna 906 on the substrate 908, a second end 910 of antenna wire 904 is preferably held by the same or another holding device 900. Only thereafter are the ends 902 and 910 attached to corresponding terminals of a chip module 912, as the ends are held by holding device or devices 900 and not attached to substrate 908.

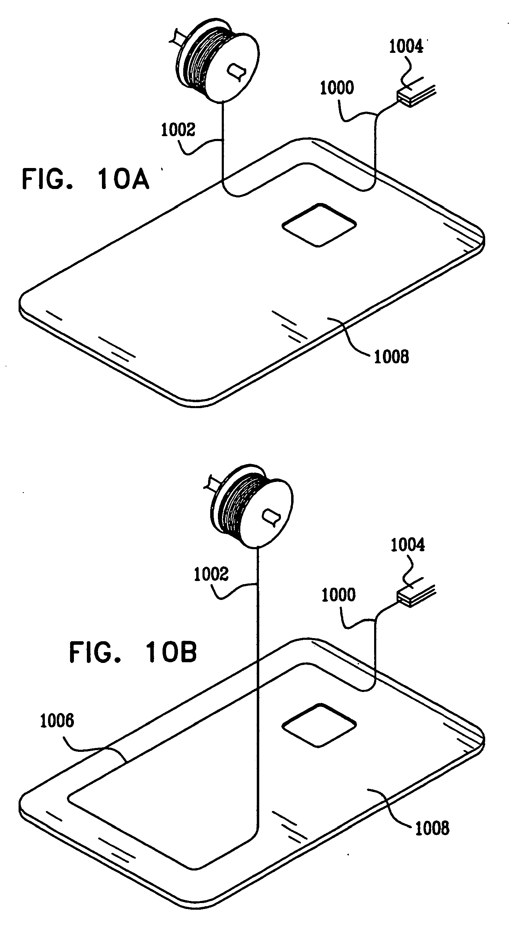

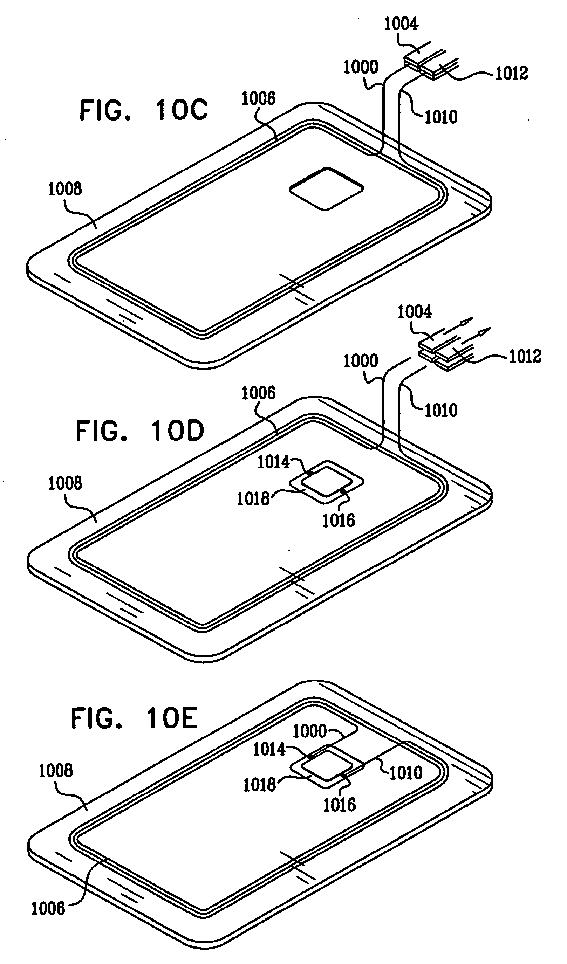

A manual manufacturing process suitable for carrying out the method of Figs. 9A and 9B is illustrated in Figs. 10A - 10E, it being appreciated that a corresponding automated manufacturing process may readily be provided.

As seen in Figs. 10A & 10B, a first end 1000 of antenna wire 1002 is held by a first gripper 1004 as a wire antenna 1006 is formed from antenna wire 1002 on a substrate 1008 in an otherwise conventional manner, such as by ultrasonic embedding. Fig. 10e shows a second end 1010 of the antenna wire 1002 being held by a second gripper 1012 following completion of the wire antenna 1006 and Fig. 10D shows ends 1000 and 1010 having been released from grippers 1004 and 1012 respectively following completion of the wire antenna. Fig. 10E shows attachment of ends 1000 and 1010 to respective terminals 1014 and 1016 of a chip module 1018 mounted on substrate 1008.

It is appreciated that second gripper 1012 may be obviated and first gripper 1004 may be configured to grip both first end 1000 and second end 1010 of antenna wire 1002, similar to holding device 900 of Figs. 9A and 9B. It is also appreciated that a first and second gripper, such as grippers 1004 and 1012, may be used instead of holding device 900 of the embodiment shown in Figs. 9A and 9B.

## Claims

1. A method for manufacturing a smart card inlay comprising:
- attaching a first and a second end (702, 704; 800, 810) of a single wire antenna (700; 806) to a single first substrate (708; 804);
- fixing said wire antenna (700; 806), aside from the first and second ends (702, 704; 800, 810) thereof, to a second substrate (706; 808);
said method being **characterized by** further comprising:
- thereafter relocating said first substrate (708; 804) relative to said second substrate (706; 808) such that said first and second ends (702, 704; 800, 810) of said wire antenna (700; 806) are at locations on said second substrate (706; 808) suitable for connection to a chip module (710; 812);
- thereafter connecting said first end (702; 800) and said second end (704; 810) to said chip module (710; 812); and
- thereafter removing said first substrate (708; 804).

2. A method for manufacturing a smart card inlay according to claim 1, wherein said attaching first and second ends (800; 810) of a wire antenna (806) to a first substrate (804) comprises:
- connecting said first end (800) prior to said fixing said wire antenna (806); and
- connecting said second end (810) subsequent to said fixing said wire antenna (806).

3. A method for manufacturing a smart card inlay according to claim 1 or 2, wherein said fixing the wire antenna (700; 806) comprises:
- removably mounting said substrate (706; 808) onto a movable surface; and
- moving said substrate (706; 808) relative to a fixed wire embedding device for fixing said wire antenna (700; 806) to said substrate (796; 808).

4. A system for manufacturing a smart card inlay comprising:
- a wire attaching tool operative to attach first and second ends (702, 704; 800, 810) of a wire antenna (700; 806) to a first substrate (708; 804);
- a wire antenna placement tool operative to fix said wire antenna (700; 806), aside from said first and second ends (702, 704; 800, 810) thereof, to a second substrate (706; 808);
said system being **characterized by** further comprising:
- a substrate relocating tool operative to thereafter relocate said first substrate (708; 804) relative to said second substrate (706; 808) such that first and second ends (702, 704; 800, 810) of said wire antenna (700; 806) are at locations on said second substrate (706; 808) suitable for connection to a chip module (710; 812);
- an electrical connecting tool operative to thereafter connect said first end (702; 800) and said second end (704; 810) to said chip module (710; 812); and
- a substrate removing tool operative to thereafter remove said first substrate (708; 804).

5. A system for manufacturing a smart card inlay according to claim 4, wherein said wire attaching tool is operative to:
- connect said first end (800) prior to said fixing said wire antenna (806) to a substrate (808); and
- connect said second end (810) subsequent to said wire antenna placement tool said fixing wire antenna to a substrate (808).

6. A system for manufacturing a smart card inlay according to claim 4 or 5, wherein said wire antenna placement tool comprises:
- a fixed wire embedding device operative to fix said wire antenna (700; 806) to said substrate (706; 808); and
- a movable surface operative to move said substrate (706; 808); relative to a fixed wire embedding device.

## Patentansprüche

1. Verfahren zur Herstellung eines Chipkarten-Inlays, umfassend:
- Befestigen eines ersten und eines zweites Endes (702, 704; 800, 810) von einer Einzel-Drahtantenne (700; 806) an einem einzelnen ersten Substrat (708; 804),
- Fixieren der Drahtantenne (700; 806) abseits der Befestigung des ersten und zweiten Endes (702, 704; 800, 810) an einem zweiten Substrat (706; 808),
wobei das Verfahren durch die folgenden weiteren Schritte gekennzeichnet ist:
- anschließendes Positionieren des ersten Substrats (708; 804) relativ zu dem zweiten Substrat (706; 808), so dass sich das erste und das zweite Ende (702, 704; 800, 810) der Drahtantenne (700; 806) auf dem zweiten Substrat (706; 808) an Positionen befinden, die zur Verbindung mit einem Chipmodul (710; 812) geeignet sind;
- anschließendes Verbinden des ersten Endes (702; 800) und des zweiten Endes (704; 810) mit dem Chipmodul (710; 812); und
- anschließendes Entfernen des ersten Substrats (708; 804).

2. Verfahren zur Herstellung eines Chipkarten-Inlays nach Anspruch 1, wobei das Befestigen des ersten und des zweiten Endes (800; 810) von einer Drahtantenne (806) an dem ersten Substrat (804) Folgendes umfasst:
- Verbinden des ersten Endes (800) vor dem Fixieren der Drahtantenne (806); und
- Verbinden des zweiten Endes (810) nach dem Fixieren der Drahtantenne (806).

3. Verfahren zur Herstellung eines Chipkarten-Inlays nach Anspruch 1 oder 2, wobei das Fixieren der Drahtantenne (700; 806) Folgendes umfasst:
- lösbare Montage des Substrats (706; 808) auf einer beweglichen Oberfläche; und
- Bewegen des Substrates (706; 808) relativ zu einer feststehenden Drahtverlegeeinrichtung zum Fixieren der Drahtantenne (700; 806) an dem Substrat (796; 808).

4. System zur Herstellung eines Chipkarten-Inlays, umfassend:
- eine Drahtbefestigungsvorrichtung, die ausgelegt ist, das erste und das zweite Ende (702, 704; 800, 810) von einer Drahtantenne (700; 806) mit einem ersten Substrat (708; 804) zu verbinden,
- eine Drahtantennen-Platzierungsvorrichtung, die ausgelegt ist, die Drahtantenne (700; 806) abseits der Befestigung des ersten und zweiten Endes (702, 704; 800, 810) an einem zweiten Substrat (706, 808) zu fixieren;
wobei das System zudem **gekennzeichnet ist durch**:
- eine Substratpositionierungsvorrichtung, die ausgelegt ist, das erste Substrat (708; 804) anschießend relativ zu dem zweiten Substrat (706; 808) so zu positionieren, dass sich das erste und das zweite Ende (702, 704; 800, 810) der Drahtantenne (700; 806) auf dem zweiten Substrat (706; 808) an Positionen befinden, die zur Verbindung eines Chipmoduls (710; 812) geeignet sind;
- eine Elektro-Verbindungsvorrichtung, die ausgelegt ist, das erste Ende (702; 800) und das zweite Ende (704; 810) anschließend mit dem Chipmodul (710; 812) zu verbinden; und
- eine Substrat-Entfernungsvorrichtung, die ausgelegt ist, das erste Substrat (708; 804) anschließend zu entfernen.

5. System zur Herstellung eines Chipkarten-Inlays nach Anspruch 4, wobei die Drahtbefestigungsvorrichtung dazu ausgelegt ist:
- das erste Ende (800) vor dem Fixieren der Drahtantenne (806) an einem Substrat (808) zu verbinden; und
- das zweite Ende (810) nach dem Fixieren der Drahtantenne an einem Substrat (808) vermittels der Drahtantennen-Platzierungsvorrichtung zu verbinden.

6. System zur Herstellung eines Chipkarten-Inlays nach Anspruch 4 oder 5, wobei die Drahtantennen-Platzierungsvorrichtung Folgendes umfasst:
- eine feststehende Drahtverlegeeinrichtung, die ausgelegt ist, die Drahtantenne (700; 806) an dem Substrat (706; 808) zu fixieren, und
- eine bewegliche Oberfläche, die ausgelegt ist, das Substrat (706; 808) relativ zu einer feststehenden Drahtverlegeeinrichtung zu bewegen.

## Revendications

1. Procédé pour la fabrication d'un insert pour une carte à puce comprenant les étapes suivantes:
- fixer une première et une seconde extrémité (702, 704; 800, 810) d'une antenne unifilaire (700; 806) à un seul premier substrat (708; 804),
- fixer ladite antenne filaire (700; 806) à l'écart de ses premières et secondes extrémités (702, 704; 800, 810) à un second substrat (706; 808),
ledit procédé étant **caractérisé par** les étapes additionnelles suivantes:
- repositionner par la suite ledit premier substrat (708; 804) par rapport audit second substrat (706; 808) de telle manière que les premières et les secondes extrémités (702, 704; 800, 810) de ladite antenne filaire (700; 806) se trouvent dans des positions sur ledit second substrat (706; 808) qui sont appropriées au raccordement avec un module de puce (710; 812),
- raccorder par la suite ladite première extrémité (702; 800) et ladite seconde extrémité (704; 810) avec ledit module de puce (710; 812), et
- enlever par la suite ledit premier substrat (708; 804).

2. Procédé pour la fabrication d'un insert pour une carte à puce selon la revendication 1,
dans lequel la fixation des premières et des secondes extrémités (800; 810) d'une antenne filaire (806) à un premier substrat (804) comprend les étapes suivantes:
- raccorder ladite première extrémité (800) avant la fixation de ladite antenne filaire (806), et
- raccorder ladite seconde extrémité (810) après la fixation de ladite antenne filaire (806).

3. Procédé pour la fabrication d'un insert pour une carte à puce selon la revendication 1 ou 2, dans lequel la fixation de l'antenne filaire (700; 806) comprend les étapes suivantes:
- monter de manière amovible ledit substrat (706; 808) sur une surface mobile, et
- déplacer ledit substrat (706; 808) par rapport à un dispositif d'encastrement fixe d'un fil pour la fixation de ladite antenne filaire (700; 806) audit substrat (796; 808).

4. Système pour la fabrication d'un insert pour une carte à puce comprenant:
- un outil de fixation d'un fil prévu pour la fixation des premières et des secondes extrémités (702, 704; 800, 810) d'une antenne filaire (700; 806) à un premier substrat (708; 804),
- un outil de placement d'une antenne filaire prévu pour la fixation de ladite antenne filaire (700; 806) à l'écart de ses premières et secondes extrémités (702, 704; 800, 810) à un second substrat (706; 808),
**caractérisé en ce que** ledit système comprend en outre:
- un outil de repositionnement d'un substrat prévu pour repositionner par la suite ledit premier substrat (708; 804) par rapport audit second substrat (706; 808) de telle manière que les premières et les secondes extrémités (702, 704; 800, 810) de ladite antenne filaire (700; 806) se trouvent dans des positions sur ledit second substrat (706; 808) qui sont appropriées au raccordement avec un module de puce (710; 812),
- un outil électrique de raccordement prévu pour le raccordement par la suite de ladite première extrémité (702, 800) et ladite seconde extrémité (704, 810) avec ledit module de puce (710; 812), et
- un outil d'enlèvement d'un substrat prévu pour enlever par la suite ledit premier substrat (708; 804).

5. Système pour la fabrication d'un insert pour une carte à puce selon la revendication 4,
dans lequel l'outil de fixation d'un fil est prévu pour:
- raccorder ladite première extrémité (800) avant la fixation de ladite antenne filaire (806) à un substrat (808); et
- raccorder ladite seconde extrémité (810) suivant la fixation de l'antenne filaire à un substrat (808) par l'outil de placement d'une antenne filaire.

6. Système pour la fabrication d'un insert pour une carte à puce selon la revendication 4 ou 5, dans lequel l'outil de placement d'une antenne filaire comprend:
- un dispositif d'encastrement fixe d'un fil prévu pour la fixation de ladite antenne filaire (700; 806) audit substrat (706; 808), et
- une surface mobile prévue pour le déplacement dudit substrat (706; 808) par rapport au dispositif d'encastrement fixe d'un fil.
